(19) Europäisches Patentamt
European Patent Office
Office européen des brevets

(11) **EP 3 185 664 A1**

(12) **EUROPEAN PATENT APPLICATION**

(43) Date of publication:
**28.06.2017 Bulletin 2017/26**

(51) Int Cl.:
***H05K 7/20*** (2006.01)

(21) Application number: **15201821.4**

(22) Date of filing: **22.12.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **ABB Technology Oy**
**00380 Helsinki (FI)**

(72) Inventors:
• **Agostini, Francesco**
 **5405 Baden Daettwil (CH)**
• **Torresin, Daniele**
 **5405 Baden Daettwil (CH)**
• **Agostini, Bruno**
 **5405 Baden Daettwil (CH)**
• **Habert, Mathieu**
 **5405 Baden Daettwil (CH)**

(74) Representative: **Kolster Oy Ab**
**Salmisaarenaukio 1**
**00180 Helsinki (FI)**

(54) **A COOLING APPARATUS**

(57) The invention relates to a cooling apparatus, comprising a first evaporator section (6) with first channels, and a first condenser section (8) with second channels. In order to provide adequate cooling for electric components the cooling apparatus further comprises a second evaporator section (10) with third channels, and a base plate (11) with a first surface (12) for receiving a heat load from electric components (13). The first condenser section (8) is in fluid communication with the second evaporator section (10) for receiving fluid from the second evaporator section, for passing heat from the fluid to surroundings and for returning fluid to the second evaporator section.

FIG. 4

Description

## BACKGROUND OF THE INVENTION

### FIELD OF THE INVENTION

This invention relates to a cooling apparatus and more particularly to a cooling apparatus for cooling electric components.

### DESCRIPTION OF PRIOR ART

Previously there is known a cooling apparatus comprising a first evaporator section and a first condenser section having first and respectively second channels for passing fluid between the evaporator section and the condenser section.

The first evaporator section is arranged at a location where heat generated by electric components is passed to the evaporator section via an air flow, for instance. In this way heat generated by the electric components can be transferred from the evaporator to the condenser and dissipated into a surrounding environment.

A problem with a cooling apparatus of the above described type is that different electric components have different requirements regarding cooling. For instance, the amount of heat generated by different electric components varies significantly. Consequently the known cooling apparatus may be able to provide an adequate cooling to some components, but not to all.

## SUMMARY OF THE INVENTION

An object of the present invention is to solve the above mentioned drawback and to provide a cooling apparatus capable of providing a more efficient cooling. This object is achieved with a cooling apparatus according to independent claim 1.

The use of a second evaporator from which fluid is passed to the first condenser and of a base plate with a first surface receiving a heat load from electric components makes it possible to provide adequate cooling to electric components of different types.

## BRIEF DESCRIPTION OF DRAWINGS

In the following the present invention will be described in closer detail by way of example and with reference to the attached drawings, in which

Figures 1 to 4 illustrate a first embodiment of a cooling apparatus,
Figures 5 to 9 illustrate a second embodiment of a cooling apparatus,
Figures 10 to 11 illustrate a third embodiment of a cooling apparatus, and
Figures 12 to 13 illustrate a fourth embodiment of a cooling apparatus.

## DESCRIPTION OF AT LEAST ONE EMBODIMENT

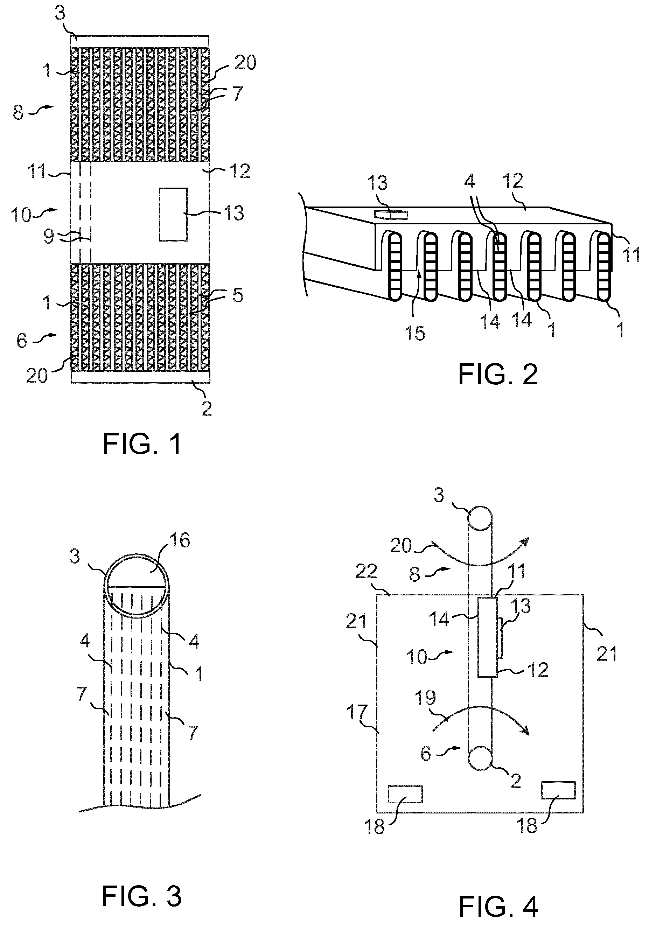

Figures 1 to 4 illustrate a first embodiment of a cooling apparatus. Figure 1 illustrates a front view of the cooling apparatus, Figure 2 illustrates a base plate and tubes, Figure 3 illustrates details of a fluid distribution element and Figure 4 illustrates a housing of the cooling apparatus.

In the illustrated example the cooling apparatus comprises a plurality of first tubes 1 arranged with spaces between them to extend between a first fluid distribution element 2 and a second fluid distribution element 3. The first tubes 1 are divided by internal longitudinal walls 4 into a plurality of channels. The first tubes may be implemented with MPE (Multi Port Extruded) tubes extruded of aluminum, for instance.

In Figure 1 the lowest parts of the channels of the first tubes 1 which are located closest to the first fluid distribution element 2 are used as first channels 5 of a first evaporator section 6. A heat load received by the first evaporator section 6 is passed into a fluid in the first channels 5.

The uppermost parts of the channels of the first tubes 1, which in Figure 1 are located closest to the second fluid distribution element 3, are used as second channels 7 of a first condenser section 8. Consequently the first condenser section 8 is in fluid communication with the first evaporator section 6 for receiving fluid and for passing heat from the fluid to surroundings.

A middle section of the channels of the first tubes 1, which in Figure 1 are located between the first evaporator section 6 and the first condenser section 8, are used as third channels 9 of a second evaporator section 10. Heat received by the second evaporator section 10 is passed into fluid in the third channels 9 which are in fluid communication with the first condenser section 8 for passing heated fluid to the first condenser section and for receiving cooled fluid from the first condenser section 8.

In the illustrated example the second evaporator section 10 is provided with a base plate 11 having a first surface 12 for receiving a heat load from electric components 13 and a second surface 14. The second surface 14 is an opposite surface in relation to the first surface 12 and is provided with grooves 15 receiving third channels 9 of the second evaporator section 10. It should, however, be observed that instead of providing the base plate 11 at the second evaporator section 10, the base plate may instead be provided at the first evaporator section 6 such that the grooves 15 instead receive first channels 5 of the first evaporator section 6.

In Figures 1 to 4 it is by way of example assumed that the cooling apparatus is a thermosiphon. In a thermosiphon gravity is utilized to return cooled fluid downwards from a condenser to an evaporator, while heat is utilized to drive evaporated fluid upwards from the evaporator to the condenser. In order to enhance such fluid circulation the grooves 15 may receive only a part of the third channels 9 of each first tube 1, as illustrated in Figure 2. In praxis it may be sufficient that the grooves 15 receive only one of the third channels 9 of each first tube 1. These third channels 9 which consequently are located within the base plate 11 are evaporator channels to which heat is most efficiently conducted from the electric components 13 via the base plate. The remaining third channels 9 provided by the first tubes 1 which are located outside of the base plate 11 are condenser channels. In praxis it may be sufficient that only one of the third channels 9 provided by the first tubes 1 are located outside of the base plate 11.

Figure 3 illustrates the second fluid distribution element 3 in more detail. The second fluid distribution element is implemented as a continuous space 16 into which all the channels of the first tube 1 open up. Consequently the fluid path provided by the second fluid distribution element interconnects all second channels 7 to each other. Therefore fluid which arrives to the second fluid distribution element via any channel may be passed on via any channel of any first tube.

In Figure 4 details of a housing 17 are illustrated. The housing 17 encloses and separates from a surrounding environment electric components 13 and 18, the first evaporator section 6 and the second evaporator section 10. One alternative is that the housing 17 is implemented as a gas tight enclosure which prevents flow of air between the outside and the inside of the housing 17.

In Figure 4 electric components 18 located in various parts within the housing 17 generate heat which is passed to the first evaporator section 6 via air within the housing 17. Preferably a fan is utilized within the housing 17 to generate an airflow 19 passing through the spaces located between the first channels 5 of the first evaporator section 16. In order to enhance heat transfer from the air flow into fluid in the first channels 5, fins 20 are preferably provided in the spaces between the channels.

Also within the housing 17 the electric components 13 generate heat. These electric components 13 are, however, attached to the base plate 11 at the second evaporator 10 in the illustrated example. Consequently, the heat from the electric components 13 is conducted via the base plate 11 into fluid in the third channels 9.

As illustrated in Figure 4, the first condenser section 8 is located outside of the housing 17, where it dissipates heat from received fluid to the surrounding environment. Preferably a fan may be used to generate an airflow passing through the spaces located between the second channels 7 of the first condenser section 8. In order to enhance dissipation of heat from the first condenser section 8, fins 20 are preferably provided in the spaces between the channels.

If the illustrated cooling apparatus is utilized for cooling a drive for an electric motor, such as a frequency converter, components 13 located on the base plate may include a high power semiconductor component, such as a IGBT (Insulated Gate Bipolar Transistor), for instance. In that case components 18 may be passive components, such as inductors, capacitors, resistors and printed circuit boards, for instance. Typically printed circuit boards need to be protected from outside air, due to which the illustrated cooling apparatus provides a very advantageous solutions for cooling such components requiring high ingress protection.

In Figure 4 it is by way of example assumed that the evaporator sections 6, 10 and the condenser section 8 are all arranged in an exactly upright position with the condenser section located on top. However, a thermosiphon does not need to be in such an exactly upright position to work. In practice it is possible that a thermosiphon is inclined with up to 70°. In that case the condenser section 8 could protrude out of the left or right side walls 21 instead as from the illustrated top wall 22 (or roof).

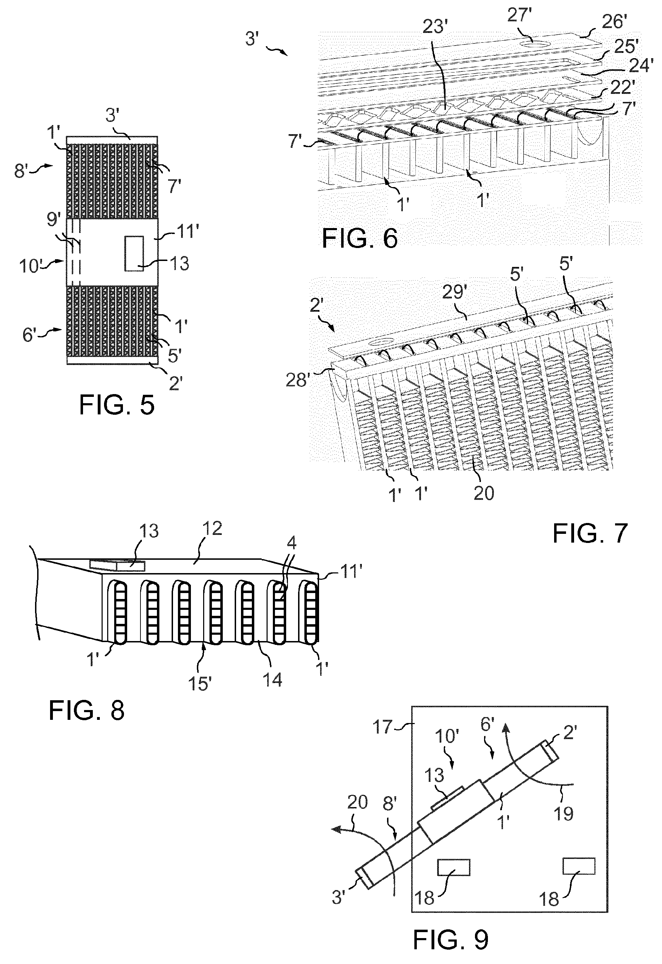

Figures 5 to 9 illustrate a second embodiment of a cooling apparatus. The embodiment of Figures 5 to 9 is very similar as the one explained in connection with Figures 1 to 4. The embodiment of Figures 5 to 9 will therefore be explained mainly by pointing out the differences between these embodiments.

The cooling element of Figures 5 to 9 is implemented to work as a pulsating heat pipe where pressure pulsation induced by capillary sized channels is utilized for moving fluid. This makes it possible to utilize the cooling element in any orientation, even with such an inclination where the first condenser section 8' is located lower than the first evaporator section 6' and the second evaporator section 10', as illustrated in Figure 9. In Figure 9 details of a housing 17 are illustrated. The first condenser section 8' protrudes out of the housing 17, while the other parts of the cooling apparatus remain within the housing 17.

In the embodiment of Figures 5 to 9 the channels of the fist tubes 1' are capillary dimensioned. Consequently they are capillary-sized for the used fluid so that no additional capillary structures are needed on their internal walls. The diameter of a channel which is considered capillary depends on the fluid that is used (boiling) inside. The following formula, for instance, can be used to evaluate a suitable diameter:

$$D = (sigma/(g*(rhol-rhov)))^0.5,$$

wherein sigma is the surface tension, g the acceleration of gravity, rhov the vapour density and rhol the liquid density. This formula gives values from 1 to 3 mm for R134a (Tetrafluoroethane), R245fa and R1234ze (Tetrafluoropropene), which are examples of fluids suitable for use in the cooling apparatus.

Figure 6 illustrates in more detail the second fluid distribution element 3'. The fluid path provided by the second fluid distribution element 3' connects each second channel 7' only to one or more other predetermined second channels. In the illustrated example this is obtained by utilizing a set of plates stacked on top of each other. A first plate 22' has openings 23' interconnecting only predetermined second channels 7' to each other. A second plate 24' and a third plate 25' have openings interconnecting second channels 7' of the outermost first tubes 1' to each other in order to provide an open loop pulsating heat pipe. A fourth plate 26' works as a lid providing a leak proof fluid distribution element, except for a hole 27' facilitating filling of the fluid distribution element. In case and open loop pulsating heat pipe is the goal, the second plate 24' and the third plate 25' can be removed.

Figure 7 illustrates in more detail the first fluid distribution element 2'. The first fluid distribution element 2' connects each first channel 5' only to one or more other predetermined first channels 5'. In the illustrated example this is done by two plates stacked against each other. The fifth plate 28' has holes facilitating fluid flow only between first channels 5' on one single first tube, while the sixth plate 29' is arranged as a lid providing a leak proof fluid distribution element. Additionally a filling hole is shown in the sixth plate 29'. Figures 6 and 7 illustrate two filling holes (in plates 27' and 29') by way of example, however, in praxis only one filling hole is sufficient.

By using fluid distribution elements 2' and 3' as explained above, the result is one single continuous flow channel having a meandering shape through the entire cooling apparatus.

Figure 8 illustrates the base plate 11' and first tubes 1'. This base plate 11' is different as compared to the one explained in connection with Figures 1 to 4 in that the grooves 15' in the second surface 14 are deeper such that all channels of the first tubes 1' are received into the grooves. In this way heat is more efficiently transferred to fluid in all channels of the first tubes 1'. In Figures 1 to 4 the illustrated apparatus is a thermosiphon where some of the channels are not in contact with the base plate so that condensed liquid can flow back to the evaporator by gravity. In Figures 5 to 9, the pulsating heat pipe does work on gravity so all the channels can be used either to evaporate or condense.

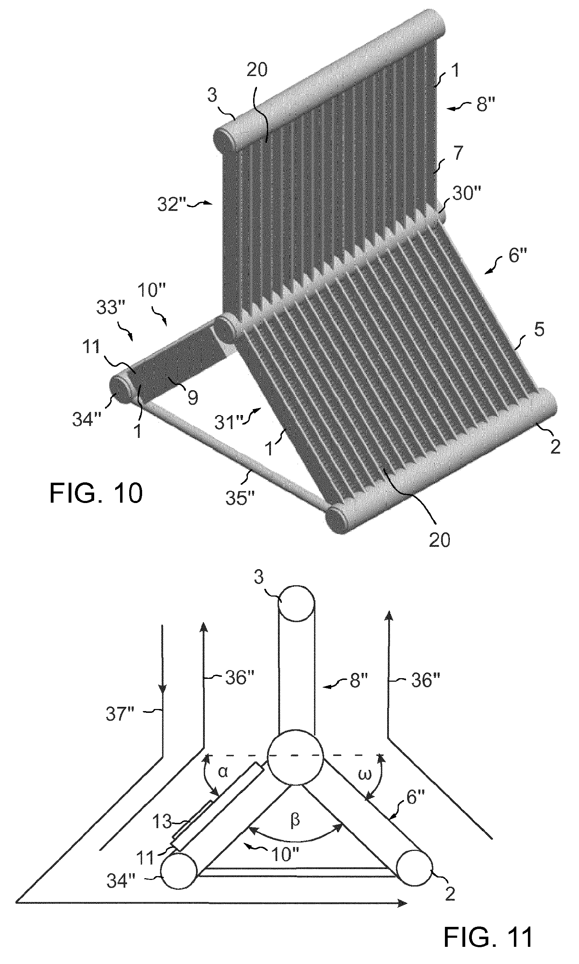

Figures 10 to 11 illustrate a third embodiment of a cooling apparatus. The cooling apparatus of Figures 10 to 11 is very similar to the one explained in connection with Figures 1 to 4. In the following the cooling apparatus of Figures 10 to 11 will be explained mainly by pointing out the differences between these embodiments.

Similarly as in the embodiment of Figures 1 to 4, the cooling apparatus of Figures 10 to 11 is a thermosiphon. A first set 31" of first tubes 1 which are divided by longitudinal internal walls into first channels 5 extend between a first fluid distribution element 2 and a center fluid distribution element 30". Fins 20 are preferably utilized in spaces between the first channels in order to facilitate that the first evaporator section 6" more efficiently receives a heat load and passes the heat load to fluid in the first channels 5.

A second set 32" of first tubes 1 which are divided by longitudinal internal walls into second channels 7 extend with spaces between them between the center fluid distribution element 30" and the second fluid distribution element 3. Preferably fins are arranged in the spaces between the first tubes. If the cooling apparatus of Figures 10 and 11 is provided with a housing, these second channels 7 of the first condenser section 8" extend out of the housing, similarly as explained in connection with Figure 4, for instance. In that case the electric components and the first 6" and second 10" evaporator sections remain on the inside of the housing.

A third set 33" of first tubes 1 which are divided by longitudinal internal walls into third channels 9 extend with spaces between them between the center fluid distribution element 30" and a third fluid distribution element 34". Similarly as has been illustrated in Figures 1 and 2, a base plate 11 with a first surface for receiving a heat load from electric components 9 and a second opposite surface with grooves receiving third channels 9 of the second evaporator section 10" has been provided at the third set 33" of first tubes 1. In the illustrated example, though not necessarily in all implementations, a fluid return pipe 35" interconnects the third fluid distribution element 34" to the first fluid distribution element 2.

In Figures 10 and 11 the first fluid distribution element 2, the center fluid distribution element 30", the second fluid distribution element 3 and the third fluid distribution element 34" may all be implemented in a similar way as explained in connection with Figure 3. These fluid distribution elements may consequently provide fluid paths between each and every channel connected to them such that fluid arriving from any channel may freely be passed on via any other channel.

Figure 11 illustrates angles which may be utilized between the various tube sets. The angles may be selected such that $(\alpha+\beta+\omega)=180°$, $\alpha>=0$ and $\omega>=0°$. Additionally Figure 11 illustrates fluid flow within the cooling apparatus. Arrows 36" illustrate the fluid path of evaporated fluid in vapour state towards the second fluid distribution element 3, while arrow 37" illustrates the fluid path of condensed fluid in liquid state from the second fluid distribution element 3.

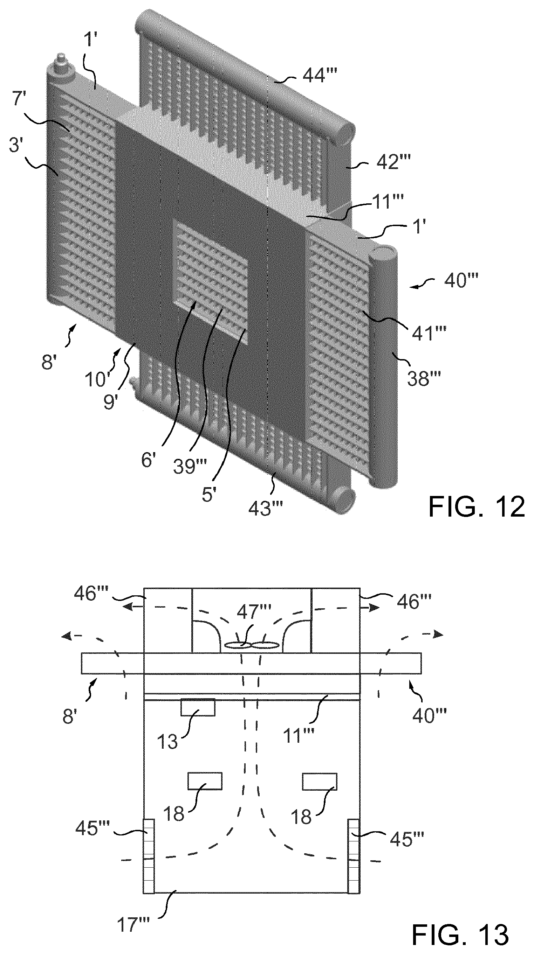

Figures 12 to 13 illustrate a fourth embodiment of a cooling apparatus. The embodiment of Figures 12 to 13 is very similar to the one explained in connection with Figures 5 to 9. The embodiment of Figures 12 to 14 will therefore be mainly explained by pointing out the differences between these embodiments.

Similarly as in the embodiment of Figures 5 to 9, the cooling apparatus of Figures 12 and 13 works as a pulsating heat pipe. The cooling apparatus comprises first tubes 1' with spaces between and which extend between a fourth fluid distribution element 38''' and the second fluid distribution element 3' . The fourth 38''' and the second 3' fluid distribution elements may be implemented with stacked plates as explained in connection with Figures 6 and 7.

In Figure 12 the leftmost parts of the channels of the first tubes 1', which in Figure 12 are located closest to the second fluid distribution element 3', are used as second channels 7' of a first condenser section 8'. A middle section of the channels of the first tubes 1', which in Figure 12 are located at (and in the figure covered by) the base plate 11''' are used as the third channels 9' of a second evaporator section 10'. However, in this embodiment the base plate 11''' is provided with a through hole 39''' allowing air flow through the base plate 11''' and between the first tubes 1' located at the through hole 39'''. The channels of the first tubes 1' located at this through hole 39''' are used as first channels 5' of the first evaporator section 6'. The rightmost parts of the channels of the first tubes 1' which in Figure 12 are located closest to the fourth fluid distribution element 38''' are used as fourth channels 41''' of a second condenser section 40'''.

In the example of Figures 12 and 13, though not necessarily in all implementations, second tubes 42''' with spaces between them and longitudinal internal walls dividing the second tubes into channels are arranged perpendicularly to the first tubes 1' to extend between a fifth fluid distribution element 43''' and a sixth fluid distribution element 44'''. Consequently, two separate elements both working as a pulsating heat pipes are used in such a way that both elements have a first and a second evaporator section and a first and a second condenser section.

Figure 13 illustrates the cooling apparatus of Figure 12 with a housing 17'''. The housing 17''' is provided with air inlets 45''' and with air outlets 46''' for allowing an airflow through the housing 17'''. In some embodiments the cooling apparatus may be provided with a fan 47''' generating a cooling airflow from the inlets 45''' through the through hole 39''' and further back to the outside of the housing via outlets 46'''. In this way heat from the electric components 18 located within the housing can be passed to the first evaporator section 6'.

As a pulsating heat pipe works in any orientation, the heat pipe or heat pipes may be horizontally oriented, as illustrated in Figure 13. In that case heat generated by the electric components 13 attached to the base plate 11''' can be dissipated to the surrounding environment outside of the housing 17''' via the first condenser section 8' and the second condenser section 40''' which protrude to the outside of the housing 17'''.

It is to be understood that the above description and the accompanying figures are only intended to illustrate the present invention. It will be obvious to a person skilled in the art that the invention can be varied and modified without departing from the scope of the invention.

**Claims**

1. A cooling apparatus, comprising:

   a first evaporator section (6, 6', 6") with first channels (5, 5') for receiving a heat load and for passing said heat load into a fluid in the first channels (5, 5'), and
   a first condenser section (8, 8', 8") with second channels (7, 7'), the first condenser section is in fluid communication with the first evaporator section (6, 6', 6") for receiving fluid from the first evaporator section, for passing heat from the fluid to surroundings and for returning fluid to the first evaporator section, **characterized in that**
   the cooling apparatus further comprises:

   a second evaporator section (10, 10', 10") with third channels (9, 9') for receiving a heat load and for passing said heat load into a fluid in the third channels, and
   a base plate (11, 11', 11''') with a first surface (12) for receiving a heat load from electric components (13), and with a second surface (14) which is opposite to the first surface and which is provided with grooves (15, 15') receiving the first channels (5, 5') of the first evaporator section or the third channels (9, 9') of the second evaporator section for passing a heat load received from the electric components (13) to fluid in the first or respectively third channels, and
   that the first condenser section (8, 8', 8") is in fluid communication with the second evaporator section (10, 10', 10") for receiving fluid from the second evaporator section, for passing heat from the fluid to surroundings and for returning fluid to the second evaporator section.

2. The cooling apparatus according to claim 1, wherein the cooling apparatus is a thermosiphon comprising a first fluid distribution element (2) interconnecting all first channels (5) to each other and a second fluid distribution element (3) interconnecting all second channels (7) to each other,
   the cooling apparatus comprises first tubes (1) arranged with spaces between them to extend between the first fluid distribution element (2) and the second fluid distribution element (3), the first tubes (1) containing a plurality of channels separated from each other by internal longitudinal walls (4), and
   the channels of the first tubes (1) in a first part of the first tubes located closest to the first fluid distribution element (2) providing said first channels (5), the channels of the first tubes in a second part of the first tubes (1) located closest to the second fluid distribution element (3) providing said second channels (7) and the channels of the first tubes in a third part of the first tubes (1) located between the first part and the second part of the first tubes providing said third channels (9).

3. The cooling apparatus according to claim 1, wherein the cooling apparatus comprises first tubes (1') arranged with spaces between them to extend between a first fluid distribution element (2') and a second fluid distribution element (3'), the first tubes containing channels separated from each other by internal longitudinal walls (4),
the channels of the first tubes in a first part of the first tubes (1') located closest to the first fluid distribution element (2') providing said first channels (5'), the channels of the first tubes in a second part of the first tubes (1') located closest to the second fluid distribution element (3') providing said second channels (7') and the channels of the first tubes in a third part of the first tubes (1') located between the first part and the second part of the first tubes providing said third channels (9'),
the first (5'), second (7') and third (9') channels are capillary dimensioned, and
in order to obtain a cooling apparatus working as a pulsating heat pipe, the first fluid distribution element (2') connects each first channel (5') to only one or more other predetermined first channels (5'), and the second fluid distribution element (3') connects each second channel (7') only to one or more other predetermined second channels (7').

4. The cooling apparatus according to claim 1, wherein the cooling apparatus is a thermosiphon comprising:

a first set (31") of first tubes (1) arranged with spaces between them to extend between a first fluid distribution element (2) and a center fluid distribution element (30"), the first set (31") of first tubes (1) containing first channels (5) separated from each other by internal longitudinal walls (4),
a second set (32") of first tubes (1) arranged with spaces between them to extend between the center fluid distribution element (30") and a second fluid distribution element (3), the second set (32") of first tubes (1) containing second channels (7) separated from each other by internal longitudinal walls (4), and
a third set (33") of first tubes (1) arranged with spaces between them to extend between a third fluid distribution (34") element and the center fluid distribution element (30"), the third set (33") of first tubes (1) containing third channels (9) separated from each other by internal longitudinal walls (4), and wherein
the first fluid distribution element (2) interconnects all first channels (5) to each other,
the second fluid distribution element (3) interconnects all second channels (7) to each other,
the third fluid distribution element (34") interconnects all third channels (9) to each other, and
the center fluid distribution element (30") interconnects all first channels (5), all second channels (7) and all third channels (9) to each other.

5. The cooling apparatus according to one of claims 1 to 4, wherein
the cooling apparatus comprises a housing (17) enclosing and separating from a surrounding environment electric components (13, 18) and at least the first evaporator section (6, 6') and the second evaporator section (10, 10'), and
the first condenser section (8, 8') is located outside of the housing (17).

6. The cooling apparatus according to claim 1, wherein the cooling apparatus comprises
a second condenser section (40''') with fourth channels (41'''), the second condenser section (40''') is in fluid communication with the first evaporator section (6') and the second evaporator section (10') for receiving fluid from the first evaporator section (6') and from the second evaporator section (10'), for passing heat from the fluid to surroundings and for returning the fluid to the first evaporator section (6') and to the second evaporator section (10)', and
first tubes (1') arranged with spaces between them to extend between a fourth fluid distribution element (38''') and a second fluid distribution element (3'), the first tubes (1') containing channels which are separated from each other by internal longitudinal walls (4), and wherein
the base plate (11''') is provided with a through hole (39''') at a location of the first evaporator section (6'), a part of the channels of the first tubes (1') located closest to the second fluid distribution element (3') providing said second channels (7'), a part of the channels of the first tubes (1') located at the base plate (11''') providing said third channels (9'), a part of the channels of the first tubes (1') located at the through hole (39''') of the base plate (11''') providing said first channels (5'), a part of the channels of the first tubes (1') located closest to the fourth fluid distribution element (38''') providing said fourth channels (41'''),
the first (5'), second (7'), third (9') and fourth channels (41''') are capillary dimensioned, and
in order to obtain a cooling apparatus working as a pulsating heat pipe, the second fluid distribution element (3') connects each second channel (7') only to one or more other predetermined second channels (7'), and the fourth fluid distribution element (38''') connects each fourth channel (41''') to only one or more other predetermined fourth channels (41''').

**7.** The cooling apparatus according to claim 6, wherein the cooling apparatus comprises second tubes (42''') arranged with spaces between them to extend between a fifth fluid distribution element (43''') and a sixth fluid distribution element (44'''), the second tubes (42''') containing capillary dimensioned channels separated from each other by internal longitudinal walls (4),

the fifth fluid distribution element (43''') connects each channel of the second tubes (42''') to only one or more other predetermined channels of the second tubes (42'''), and the sixth fluid distribution element (44''') connects each channel of the second tubes (42''') to only one or more other predetermined channels of the second tubes (42'''), and

sections of the second tubes (42''') are in contact with the first evaporator section (6') and with the second evaporator section (10') for passing a heat load into fluid in the channels of the second tubes (42''').

**8.** The cooling apparatus according to claim 6 or 7, wherein

the cooling apparatus comprises a housing (17''') enclosing and separating from an surrounding environment electric components (13, 18) and at least the first evaporator section (6') and the second evaporator section (10'),

the first condenser section (8') and the second condenser section (40''') are located outside of the housing (17'''), and

the housing (17''') comprises an inlet (45''') and an outlet (46''') for passing a cooling gas flow from the surrounding outside via the inlet (45'''), the through hole (39''') in the base plate (11'''), the first evaporator section (6') and via the outlet (46''').

**9.** The cooling apparatus according to claim 8, wherein the cooling apparatus comprises a fan (47''') for generating said cooling gas flow.

**10.** The cooling apparatus according to one of claims 2 to 9, wherein fins are arranged in the spaces between the first tubes (1, 1') to extend between adjacent first tubes (1, 1')

**FIG. 1**

**FIG. 2**

**FIG. 3**

**FIG. 4**

FIG. 5

FIG. 6

FIG. 7

FIG. 8

FIG. 9

FIG. 10

FIG. 11

FIG. 12

FIG. 13

Europäisches
Patentamt

European
Patent Office

Office européen
des brevets

## EUROPEAN SEARCH REPORT

Application Number

EP 15 20 1821

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/279706 A1 (BASH CULLEN E [US] ET AL) 14 December 2006 (2006-12-14) | 1-7,10 | INV.<br>H05K7/20 |
| A | * paragraphs [0017] - [0021]; figures 2-4 * | 8,9 | |
| | ----- | | |
| A | US 2011/271696 A1 (HEDBERG KLAS [SE] ET AL) 10 November 2011 (2011-11-10)<br>* paragraph [0056]; figure 3 *<br>----- | 1-10 | |
| | | | TECHNICAL FIELDS SEARCHED (IPC) |
| | | | H05K |

The present search report has been drawn up for all claims

| Place of search | Date of completion of the search | Examiner |
|---|---|---|
| The Hague | 21 June 2016 | Shaalan, Mohamed |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 15 20 1821

This annex lists the patent family members relating to the patent documents cited in the above-mentioned European search report.
The members are as contained in the European Patent Office EDP file on
The European Patent Office is in no way liable for these particulars which are merely given for the purpose of information.

21-06-2016

| Patent document cited in search report | | Publication date | Patent family member(s) | | Publication date |
|---|---|---|---|---|---|
| US 2006279706 | A1 | 14-12-2006 | NONE | | |
| US 2011271696 | A1 | 10-11-2011 | EP | 2377379 A1 | 19-10-2011 |
| | | | US | 2011271696 A1 | 10-11-2011 |
| | | | WO | 2010082875 A1 | 22-07-2010 |

EPO FORM P0459

For more details about this annex : see Official Journal of the European Patent Office, No. 12/82